# EUROPÄISCHE PATENTANMELDUNG

(11) **EP 0 939 144 A2**
(43) Veröffentlichungstag der Anmeldung: **01.09.1999**
(21) Anmeldenummer: 99102441.5
(22) Anmeldetag: 09.02.1999
(51) Int. Cl.: C23C 14/02, C23C 16/02, C23C 28/00

(54) **Körper mit beschichteter Oberfläche**

(30) Priorität: 27.02.1998 DE 19808508
(71) Anmelder: FRIEDRICH GROHE AKTIENGESELLSCHAFT, D-58675 Hemer (DE)
(72) Erfinder: Kleinhans, Werner, 59425 Unna (DE)

(57) **Zusammenfassung**

Es wird ein Körper, insbesondere Sanitärarmaturenkörper, mit einer Grundbeschichtung und einer Deckbeschichtung sowie ein Verfahren zur Beschichtung des Körpers beschrieben, wobei die Grundbeschichtung aus einem elektrisch leitfähigen Kunststoff besteht, auf der im PVD oder PECVD-Verfahren wenigstens eine Hartstoffbeschichtung als Deckbeschichtung aufgebracht ist.

## Beschreibung

Die Erfindung betrifft einen Körper, insbesondere Sanitärarmaturenkörper, mit wenigstens einer auf der Oberfläche vorgesehenen Grundbeschichtung, auf der wenigstens eine dekorative und/oder metallfarbige mit einem Plasmaprozeß im Vakuum erzeugte Deckschicht angeordnet ist.
Es sind bereits derartige Beschichtungen auf Körperoberflächen bekannt. Es sei hierzu beispielsweise auf die deutsche Offenlegungsschrift DE 196 18 863 A1 hingewiesen. Bei diesen bekannten Beschichtungen ist es erforderlich, daß zunächst auf der Oberfläche des Körpers galvanisch mehrere Metallschichten, beispielsweise Kupfer-, Nickel- und Chromschichten, abgeschieden werden. Auf die galvanisch abgeschiedenen Metallschichten wird danach wenigstens eine dekorative und abriebfeste Deckschicht mit einem Plasmaprozeß im Vakuum (PVD-Verfahren/PECVD-Verfahren) aufgebracht. Hierbei müssen jedoch folgende Nachteile in Kauf genommen werden:
1. Die Korrosionsbeständigkeit des Schichtsystems ist abhängig von der Güte der galvanisch aufgebrachten Grundschicht, bzw. der nacheinander aufgebrachten Kupfer-, Nickel- und Chromschichten oder der Hartstoffschicht.
2. Alle Fehler aus dem galvanischen Prozeß werden mit der nachfolgenden PVD- oder PECVD-Beschichtung deutlicher sichtbar (Pickel und Trocknungsflecken). Zur Vermeidung von Trocknungsflecken aus dem galvanischen Prozeß sind aufwendige gesonderte Reinigungsschritte und/oder Kontrollmaßnahmen erforderlich.
3. Sollen Kunststoffteile mit einer entsprechenden Beschichtung versehen werden, so müssen diese Teile ebenfalls zunächst galvanisch beschichtet sein, damit die für den PVD-Beschichtungsprozeß notwendige elektrische Leitfähigkeit gegeben ist. Die Entfernung von Flecken, die bei dem galvanischen Prozeß auf der Oberfläche entstehen können, ist bei Kunststoffteilen, insbesondere wegen ihrer Wärmeempfindlichkeit, jedoch besonders schwierig.

Der Erfindung liegt die Aufgabe zugrunde, einen verbesserten und kostengünstig herstellbaren Körper mit beschichteter Oberfläche zu schaffen sowie ein Verfahren zur Herstellung des Körpers vorzuschlagen.

Diese Aufgabe wird erfindungsgemäß mit den Merkmalen des Anspruchs 1 bzw. den Merkmalen des Anspruchs 6 gelöst.
Weitere Ausgestaltungen der Erfindung sind in den Ansprüchen 2 bis 5 und 7 bis 8 angegeben.

Ein ohne Zusätze elektrisch leitfähiger Kunststoff ist aus dem Aufsatz "Organische Metalle - Neue Möglichkeiten beim Korrosionsschutz" der Zeitschrift JOT 1997/6, Seite 18 bis 20, bekannt.
Bei der Verwendung einer Grundbeschichtung aus einem elektrisch leitfähigen Kunststoff kann auf die Galvanisierung von Kunststoffkörpern oder -teilen verzichtet werden.
Darüber hinaus kann auch bei Metallteilen bei der Verwendung einer elektrisch leitfähigen Kunststoffbeschichtung auf der Basis von beispielsweise Polyphenylenamin ein Korrosionsschutz erzielt werden, der die galvanische Beschichtung ersetzen kann. In Verbindung mit einer darauf im PVD- oder PECVD-Verfahren abgeschiedenen Hartstoffschicht kann somit eine kostengünstige und qualitativ hochwertige Beschichtung zur Verfügung gestellt werden.

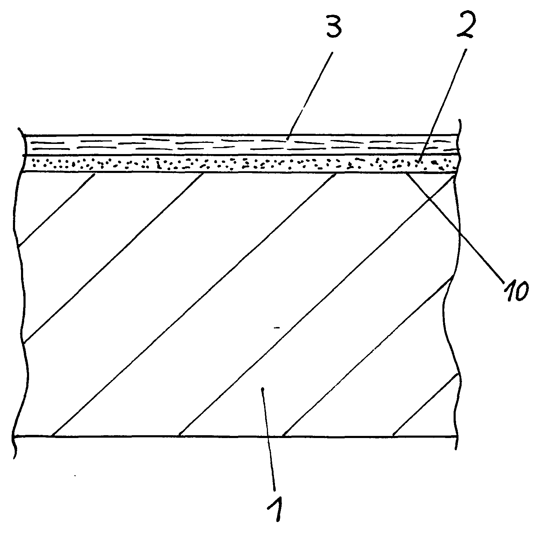

Ein Ausführungsbeispiel der Erfindung ist in der Zeichnung in Form eines im Schnitt in schematischer Weise dargestellten Teil eines Körpers angegeben und wird im folgenden näher beschrieben.
Der in der Zeichnung dargestellte aus dem Körper herausgebrochene Teil weist eine Wandung 1 mit einer Oberfläche 10 auf, die eine für den jeweils vorgesehenen Einsatzzweck des Fertigteils vorgeschriebene definierte Oberflächengüte aufweist. Auf der definierten Oberfläche 10 ist eine Grundschicht 2 aus elektrisch leitfähigem Kunststoff angeordnet. Der Kunststoff kann beispielsweise in Lackform auf die Oberfläche aufgebracht werden. Auf der erhärteten Grundschicht 2 ist eine Hartstoffschicht 3 aus z.B. Zirkoniumnitrid oder Chromnitrid im PVD-Verfahren oder PECVD-Verfahren aufgebracht.
Die Dicke der Grundschicht 2 kann etwa 0,08 bis 30 µm betragen. Zweckmäßig wird eine Schichtdicke von 5 bis 20 µm eingesetzt.

Die Herstellung des beschichteten Körpers kann in folgender Weise erfolgen:
Zunächst wird der Körper in einer Spritzgießform aus Kunststoff hergestellt, wobei die äußere Oberfläche 10 durch die Spritzgießform mit einer definierten Oberfläche versehen sein kann. Alternativ kann der Spritzgießrohling an der Oberfläche 10 aber auch bis zum Erreichen der erforderlichen Oberflächengüte anschließend bearbeitet werden.
Hiernach kann durch Spritzen, Tauchen etc. die Grundschicht 2 des elektrisch leitfähigen Kunststoffs auf der Basis von Polyphenylenamin, vorzugsweise in Lackform, aufgebracht werden.
Nach dem Erhärten der Grundschicht 2 kann dann in bekannter Weise die Hartstoffschicht 3 im PVD- oder PECVD-Verfahren aufgebracht werden.

Bei dem vorstehend aufgeführten Ausführungsbeispiel ist der Körper bzw. das Substrat, auf dem die Beschichtung aufgebracht ist, aus Kunststoff. Selbstverständlich kann der Körper bzw. das Substrat auch aus Metall bestehen.
Darüber hinaus kann die Hartstoffschicht 2 anstatt aus Zirkoniumnitrid oder aus Chromnitrid auch aus anderen Metallnitriden, Carbiden oder Carbonitriden oder ähnlichen Hartstoffen bestehen. Auch kann auf der Grundschicht 2 zunächst eine oder mehrere metallische Zwischenschicht(en) im PVD- oder PECVD-Verfahren aufgebracht werden, wonach dann als Deckschicht die Hartstoffschicht vorgesehen wird.

## Patentansprüche

1. Körper, insbesondere Sanitärarmaturenkörper, mit wenigstens einer auf der Oberfläche (10) vorgesehenen Grundbeschichtung (2), auf der wenigstens eine dekorative und/oder metallfarbige mit einem Plasmaprozeß im Vakuum (PVD-Verfahren/PECVD-Verfahren) erzeugte Deckschicht angeordnet ist, dadurch gekennzeichnet, daß die Grundschicht (2) aus einem elektrisch leitfähigen Kunststoff besteht, auf dem im PVD- oder PECVD-Verfahren wenigstens eine Hartstoffschicht (3) aufgebracht ist.

2. Körper nach Anspruch 1, dadurch gekennzeichnet, daß die Grundschicht (2) aus Kunststoff auf der Basis von Polyphenylenamin besteht.

3. Körper nach Anspruch 1 oder 2, dadurch gekennzeichnet, daß er ein aus Kunststoff hergestellter Armaturenkörper oder ein aus Kunststoff hergestellter Teil eines Armaturenkörpers ist, der an der Oberfläche (10) mit der Beschichtung versehen ist.

4. Körper nach Anspruch 1 oder 2, dadurch gekennzeichnet, daß er ein aus Metall hergestellter Armaturenkörper oder ein aus Metall hergestellter Teil eines Armaturenkörpers ist, der an der Oberfläche (10) mit der Beschichtung versehen ist.

5. Körper nach wenigstens einem der Ansprüche 1 bis 4, dadurch gekennzeichnet, daß die Hartstoffbeschichtung (2) aus einem Metallnitrid, Metallcarbid oder Metallcarbonitrid besteht.

6. Verfahren zur Herstellung eines Körpers nach einem der Ansprüche 1 bis 5, dadurch gekennzeichnet, daß
a) der Körper zunächst an der zu beschichtenden Oberfläche (10) mit einer definierten Oberflächengüte versehen wird, worauf
b) die definierte Oberfläche (10) mit einer Grundschicht (2) von elektrisch leitfähigem Kunststoff überzogen wird,
c) sodann wird auf der Grundschicht (2) wenigstens eine Hartstoffschicht (3) im PVD-Verfahren oder PECVD-Verfahren aufgebracht.

7. Verfahren nach Anspruch 6, dadurch gekennzeichnet, daß auf die mit einer definierten Oberflächengüte versehene Oberfläche (10) ein Kunststoff auf der Basis von Polyphenylenamin in Form eines Lacks als Grundschicht (2) aufgebracht wird, wobei die Schichtdicke des Lackes 0,08 bis 30 µm, vorzugsweise 5 bis 20 µm, nach der Aushärtung beträgt.

8. Verfahren nach Anspruch 6 oder 7, dadurch gekennzeichnet, daß nach dem Aufbringen der aus Kunststoff bestehenden Grundschicht (2) mit dem PVD- oder PECVD-Verfahren zunächst wenigstens eine metallische Zwischenschicht und danach die Hartstoffschicht (3) aufgebracht wird.
